# EUROPEAN PATENT SPECIFICATION

(11) **EP 2 876 802 B1**
(45) Date of publication and mention of the grant of the patent: **30.08.2017**
(21) Application number: 13820027.4
(22) Date of filing: 30.05.2013
(51) Int. Cl.: H02M 7/48, H05K 7/14, H05K 7/20

(54) **INVERTER DEVICE**
UMRICHTERVORRICHTUNG
DISPOSITIF ONDULEUR

(30) Priority: 20.07.2012 JP 2012161862
(43) Date of publication of application: 27.05.2015
(73) Proprietor: Fuji Electric Co., Ltd., Kawasaki-shi Kanagawa 210-9530 (JP)
(72) Inventor: FUKUCHI, Shun, Kawasaki-shi Kanagawa 210-9530 (JP)
(74) Representative: Appelt, Christian W.
(86) International application number: PCT/JP2013/065042
(87) International publication number: WO 2014/013799

(56) References cited:
- JP-A- H09 275 676
- JP-A- 2000 195 685
- JP-A- 2002 095 109
- JP-A- 2003 004 170
- JP-A- 2005 348 534
- JP-U- H0 168 627
- US-A- 4 394 706
- US-A- 5 091 823
- US-A1- 2005 225 947
- US-A1- 2006 171 115
- US-A1- 2012 262 968
- US-A1- 2012 262 969

## Description

### Technical Field

The present invention relates to an inverter device.

### Background Art

Heretofore, in an inverter device which receives alternating current power from a commercial alternating current power supply or the like, converts the alternating current power to alternating current power of an optical frequency and voltage, and outputs the alternating current power, thereby driving a load, a control chamber which mainly houses various control circuit devices and a heat dissipation chamber which mainly houses heat dissipation devices for cooling the internal atmosphere of the control chamber are provided by assembling a frame and individual covers, and the two chambers are installed side by side in a manner such as to be adjacent to each other.

Further, the control chamber, from its characteristics, is waterproofed, thereby securing waterproof properties. Meanwhile, the heat dissipation chamber has the configuration of taking in outside air, and one portion of the heat dissipation chamber is opened to the external.

In this kind of inverter device, there is a case in which it is required that distribution cables are laid so as to interconnect the control chamber and heat dissipation chamber, but in this case, it happens that a through hole is formed in a cover defining the control chamber and heat dissipation chamber, and that the distribution cables are laid in a manner such as to pass through such a through hole.

However, when the distribution cables are laid in a manner such as to pass through the through hole in this way, there is fear that rainwater or the like having intruded in the heat dissipation chamber intrudes into the control chamber along the distribution cables.

Therefore, in order to prevent rainwater or the like from intruding into the control chamber, the technology of filling a gap between the through hole and the distribution cables with a sealing resin is proposed (for example, refer to PTL 1).

### Citation List

### Patent Literature

PTL 1: JP-A-2005-019791

### Summary of Invention

### Technical Problem

However, in the heretofore described technology proposed in PTL 1, as the gap between the through hole and the distribution cables is filled with a sealing resin, there is fear that rainwater or the like intrudes into the control chamber when the filling is insufficient, and the work of filling the gap with a sealing resin has been required of high accuracy. Also, there is the problem of an increase in man-hour due to performing an additional process such as filling the gap with a sealing resin after having caused the distribution cables to pass through the through hole. Because of this, manufacturing work has been complicated in order to secure good waterproof properties.

The invention, bearing in mind the heretofore described circumstances, has for its object to provide an inverter device wherein it is possible for the control chamber to secure good waterproof properties with simple work.

### Solution to Problem

In order to achieve the heretofore described object, the invention relates to an inverter device wherein a control chamber, which mainly houses various control circuit devices and the waterproof properties of which are secured, and a heat dissipation chamber, which mainly houses heat dissipation devices for cooling the internal atmosphere of the control chamber and one portion of which is opened to the external, are installed side by side so as to be adjacent to each other. The inverter device according to the invention includes a cylindrical grommet member which is provided in a condition in which one portion of the grommet member is inserted in a hole portion formed in a cover member interposed between the control chamber and the heat dissipation chamber, and which is disposed in a manner such that distribution cables connected between the control chamber and the heat dissipation chamber pass through a hollow portion of the grommet member. The grommet member has a base portion mounted in the hole portion in a condition in which the base portion passes through the hole portion; and a guide portion of which a base end portion extends from the base portion toward the heat dissipation chamber and a leading end portion continuous with the base end portion curves downward.

Also, the invention is such that in the inverter device, the guide portion is formed from the same resin material as that of the base portion and configured integrally with the base portion, and is smaller in thickness and softer than the base portion.

Also, the invention is such that in the inverter device, a level difference is formed in the base portion by an inner surface of the base portion in a region thereof close to the control chamber projecting inward.

Also, the invention is such that in the inverter device, a slit is formed in a lower portion over the entire length of the grommet member.

### Advantageous Effects of Invention

According to the invention, a cylindrical grommet member, a base portion of which is mounted in a hole portion formed in a cover member interposed between a control chamber and a heat dissipation chamber, is disposed in a manner such that distribution cables connected between the control chamber and the heat dissipation chamber pass through a hollow portion. Further, a guide portion of the grommet member is such that a base end portion extends from the base portion toward the heat dissipation chamber and a leading end portion continuous with the base end portion curves downward. By so doing, even in the event that rainwater intrudes into the heat dissipation chamber from the external, there is no fear that the rainwater intrudes into the hollow portion through an opening at the leading end portion of the grommet member, and there is no fear either that the rainwater intrudes even into the inside of the grommet member along the distribution cables. Because of this, it is possible to sufficiently secure the waterproof properties of the control chamber. Moreover, there is no need for work such as filling with a sealing resin, as heretofore known, and it is only necessary to press the base portion of the grommet member into the hole portion after having allowed the distribution cables to pass through the hollow portion of the grommet member, meaning that mounting work is also simple. Consequently, the effect of it being possible for the control chamber to secure good waterproof properties with simple work is produced.

### Brief Description of Drawings

[Fig. 1] Fig. 1 is a perspective view showing an inverter device which is an embodiment of the invention.
[Fig. 2] Fig. 2 is a front view showing the inverter device which is the embodiment of the invention.
[Fig. 3] Fig. 3 is an illustration showing a case in which the longitudinal sectional shape of the inverter device which is the embodiment of the invention is seen from diagonally above.
[Fig. 4] Fig. 4 is an illustration showing in an enlarged dimension the main portion in Fig. 3.
[Fig. 5] Fig. 5 is a side view showing in an enlarged dimension a grommet member shown in Figs. 3 and 4.
[Fig. 6] Fig. 6 is a longitudinal sectional view showing in an enlarged dimension the grommet member shown in Figs. 3 and 4.
[Fig. 7] Fig. 7 is a bottom view showing in an enlarged dimension the grommet member shown in Figs. 3 and 4.

### Description of Embodiments

Hereafter, a detailed description will be given, referring to the accompanying drawings, of a preferred embodiment of an inverter device according to the invention.

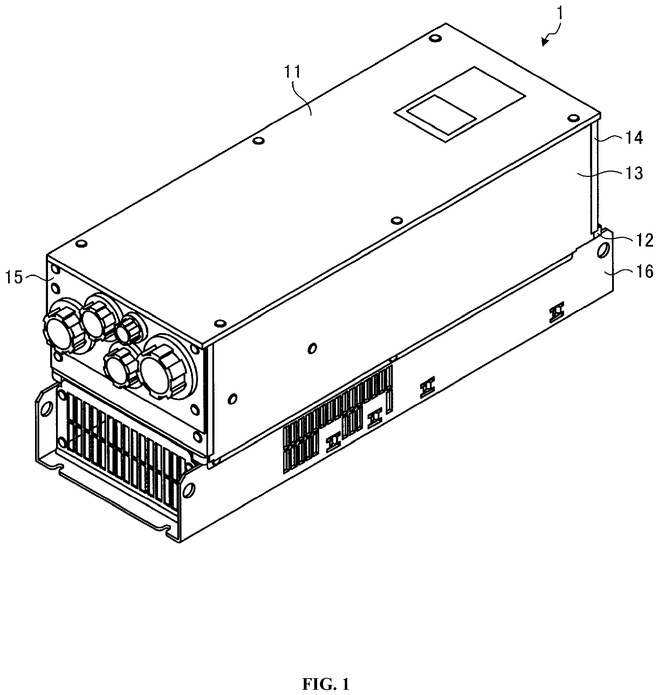

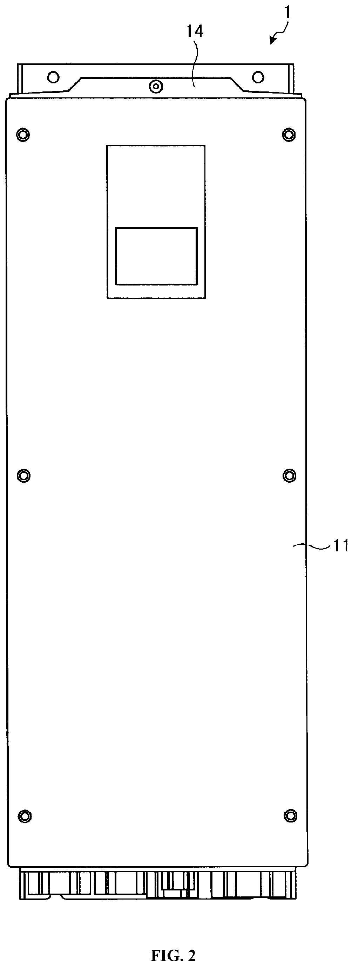

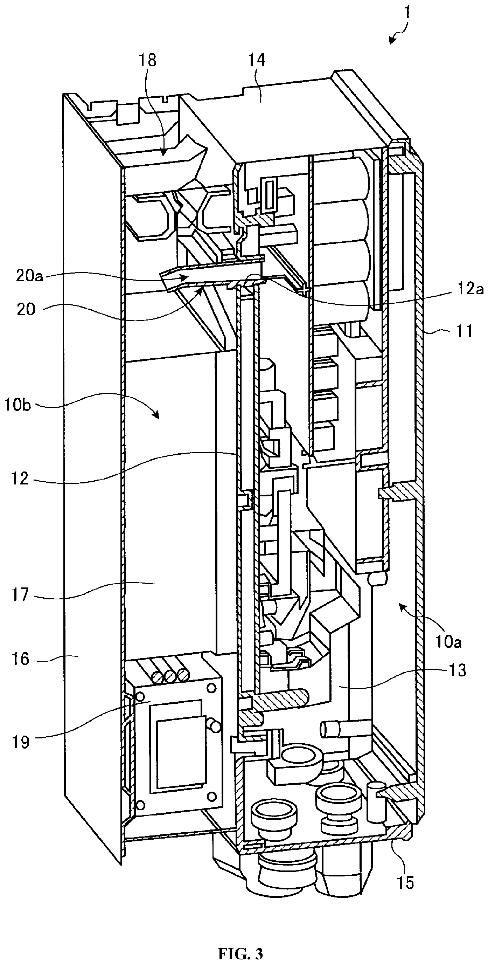

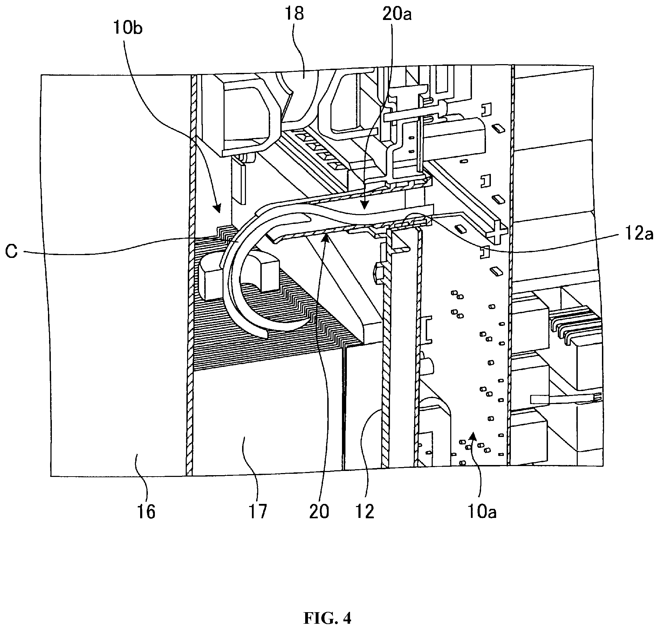

Figs. 1 to 4 each show an inverter device which is the embodiment of the invention, wherein Fig. 1 is a perspective view, Fig. 2 is a front view, Fig. 3 is an illustration showing a case in which a longitudinal sectional shape is seen from diagonally above, and Fig. 4 is an illustration showing in an enlarged dimension the main portion in Fig. 3. An inverter device 1 illustrated here converts alternating current power supplied from a commercial power supply to alternating current power of a desired frequency and voltage, and outputs the alternating current power.

In the inverter device 1, a control chamber 10a is defined by a front surface cover 11, a rear surface cover (cover member) 12, a pair of left and right side covers 13, a top plate 14, and a bottom plate 15, while a heat dissipation chamber 10b is defined by the rear surface cover 12 and a frame 16. In this way, in the inverter device 1, the control chamber 10a and the heat dissipation chamber 10b are installed side by side, with the rear surface cover 12 interposed therebetween, in a manner such as to be adjacent to each other in a front-rear direction.

The control chamber 10a, housing various control circuit devices, is such that the waterproof properties thereof are secured by waterproofing the junction areas of the covers.

Cooling fins 17 and a cooling fan 18 which are heat dissipation devices for cooling heat generating parts disposed on the control chamber 10a side and cooling the internal atmosphere of the control chamber 10a are housed, and a direct current reactor (DCR) 19 is housed in the heat dissipation chamber 10b. An opening is formed in a predetermined portion, such as at the upper end face or lower end face, of the frame 16, and one portion of the opening is opened to the external.

A through hole (hole portion) 12a is formed in the rear surface cover 12 interposed between these kinds of control chamber 10a and heat dissipation chamber 10b. The through hole 12a is for laying distribution cables C connected between the control chamber 10a and the heat dissipation chamber 10b, more particularly, a distribution cable C connecting the output terminal of a predetermined control circuit device in the control chamber 10a and the input terminal of the direct current reactor 19 in the heat dissipation chamber 10b, and a distribution cable C connecting the output terminal of the direct current reactor 19 and the input terminal of another control circuit device in the control chamber 10a.

A grommet member 20 is provided in the inverter device 1, which is the embodiment, in a manner such that one portion of the grommet member 20 is inserted in the through hole 12a.

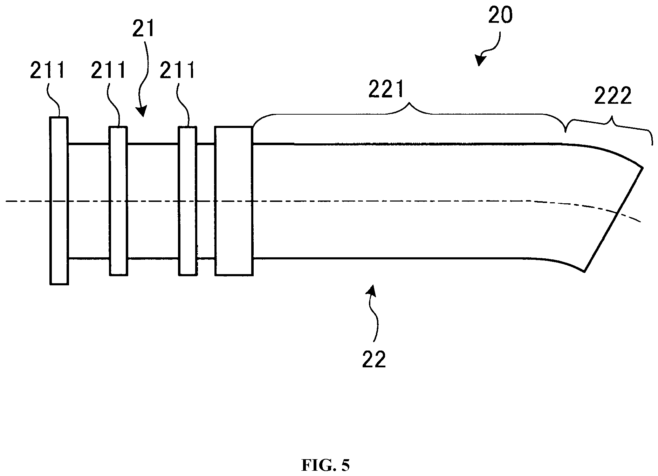

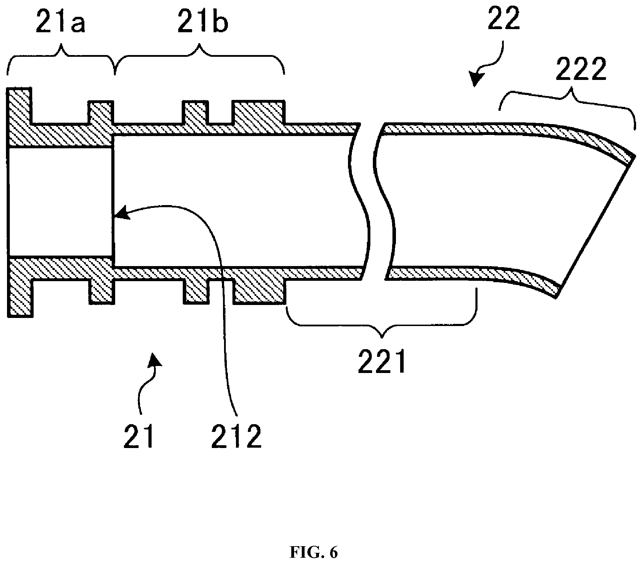

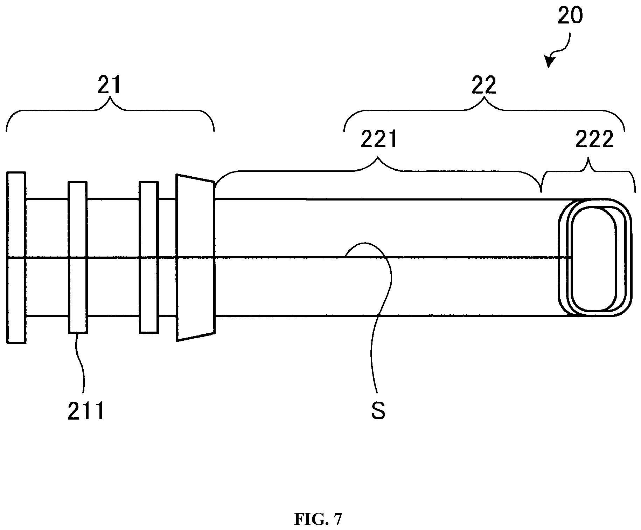

Figs . 5 to 7 each show in an enlarged dimension the grommet member shown in Figs. 3 and 4, wherein Fig. 5 is a side view, Fig. 6 is a longitudinal sectional view, and Fig. 7 is a bottom view.

The grommet member 20 illustrated here, being formed in a cylindrical shape from a resin material such as rubber, is disposed in a manner such that the distribution cables C connected between the control chamber 10a and the heat dissipation chamber 10b pass through a hollow portion 20a. The grommet member 20 is configured including a base portion 21 and a guide portion 22.

The base portion 21 is a portion forming a substantially cylindrical shape. A plurality of projecting pieces 211 projecting in a radially outward direction and extending in a circumferential direction are formed on the outer peripheral surface of the base portion 21 at predetermined intervals in an axial direction of the base portion 21. The width of this kind of base portion 21, that is, the width of portions other than the projecting pieces 211 is slightly larger than the inside diameter of the through hole 12a. Consequently, by pressing this kind of base portion 21 into the through hole 12a from the heat dissipation chamber 10b side, the base portion 21 is mounted in the through hole 12a in a condition in which the base portion 21 passes through the through hole 12a while changing elastically in shape. At this time, the base end of the base portion 21 is mounted so as to face the control chamber 10a, and the projecting pieces 211 act as restriction pieces which restrict the movement of the base portion 21.

In this kind of base portion 21, the inner surface of a base end side region 21a, that is, a region close to the control chamber 10a projects inward, thereby forming a level difference 212 between the base end side region 21a and a leading end side region 21b, as shown in Fig. 6.

The guide portion 22 is provided integrally with the base portion 21 using a resin material which is the same quality material as that of the base portion 21, and has a base end portion 221 and a leading end portion 222. The base end portion 221 is a portion, formed so as to be continuous with the leading end of the base portion 21, which extends toward the heat dissipation chamber 10b in the front-rear direction (horizontal direction) with the central axis of the base end portion 221 coinciding with the central axis of the base portion 21. The leading end portion 222 is a portion, formed so as to be continuous with the base end portion 221, which curves downward.

In this way, the guide portion 22 is such that the central axis thereof extends in the front-rear direction in the base end portion 221 in the same way as in the base portion 21, and curves downward in the leading end portion 222, as shown in Fig. 5.

Also, the guide portion 22 is configured so as to be smaller in thickness than the base portion 21, as shown in Fig. 6, and softer than the base portion 21.

The grommet member 20 configured including the base portion 21 and guide portion 22 is such that a slit S is formed in a lower portion over the entire length of the grommet member 20, as shown in Fig. 7.

In the inverter device 1 of the embodiment having the heretofore described kind of configuration, the grommet member 20 whose base portion 21 is mounted in the through hole 12a of the rear surface cover 12 is disposed in a manner such that the distribution cables C pass through the hollow portion 20a. Further, the guide portion 22 of the grommet member 20 is such that the base end portion 221 extends in the front-rear direction from the base portion 21 toward the heat dissipation chamber 10b, while the leading end portion 222 curves downward. Because of this, even in the event that rainwater intrudes through the opening formed at the upper end face or the like of the frame 16 defining the heat dissipation chamber 10b, there is no fear that the rainwater intrudes into the hollow portion 20a through the opening at the leading end portion 222 of the grommet member 20, and there is no fear either that the rainwater intrudes even into the inside of the grommet member 20 along the distribution cables C. Because of this, it is possible to sufficiently secure the waterproof properties of the control chamber 10a. Moreover, there is no need for the work of filling with a sealing resin, as heretofore known, and it is only necessary to press the base portion 21 of the grommet member 20 into the through hole 12a after having allowed the distribution cables C to pass through the hollow portion 20a of the grommet member 20, meaning that mounting work is also simple.

Consequently, according to the inverter device 1 which is the embodiment of the invention, it is possible for the control chamber 10a to secure good waterproof properties with simple work.

In the inverter device 1, as the guide portion 22 of the grommet member 20 is configured so as to be smaller in thickness than the base portion 21 and softer than the base portion 21, it is possible to easily change the shape of the guide portion 22, and thus possible to cause the guide portion 22 to follow the form in which the distribution cables C are laid.

In the inverter device 1, as the level difference 212 is formed between the base end side region 21a and leading end side region 21b of the base portion 21 of the grommet member 20 by the inner surface of the base end side region 21a projecting inward, it is possible, even in the event that water intrudes into the hollow portion 20a of the grommet member 20, to restrain the water intrusion with this kind of level difference 212, and thereby possible to more reliably secure the waterproof properties of the control chamber 10a.

In the inverter device 1, as the slit S is formed in a lower portion over the entire length of the grommet member 20, it is possible to cause the grommet member 20 to change elastically in shape in such a way as to increase the width of the slit S. By causing the grommet member 20 to change elastically in shape in this way, it is possible, even when there are a plurality of the distribution cables C, to push a bundle of the already laid plurality of distribution cables C into the hollow portion 20a via the slit S without causing the distribution cables C to pass one by one through the hollow portion 20a. Because of this, it is possible to achieve the simplification of mounting work.

Heretofore, a description has been given of a preferred embodiment of the invention, but the invention not being limited to this, it is possible to carry out various modifications.

In the heretofore described embodiment, the guide portion 22 of the grommet member 20 is formed from the same resin material as that of the base portion 21 and configured integrally with the base portion 21, but in the invention, the guide portion may be formed from a resin material different from that of the base portion, or may be subsequently joined to and configured integrally with the base portion.

In the heretofore described embodiment, the guide portion 22 of the grommet member 20 is smaller in thickness and softer than the base portion 21, but in the invention, the the guide portion may be equal in thickness to the base portion, or does not have to be softer than the base portion.

In the heretofore described embodiment, the level difference 212 is formed in the base portion 21 of the grommet member 20, but in the invention, this kind of level difference does not have to be provided.

In the heretofore described embodiment, the slit S is formed in a lower portion over the entire length of the grommet member 20, but in the invention, this kind of slit does not have to be formed.

In the heretofore described embodiment, among the distribution cables C connected between the control chamber 10a and the heat dissipation chamber 10b, one connected to the direct current reactor 19 is illustrated, but in the invention, the distribution cable, not being limited to the one connected to the direct current reactor, may be a distribution cable connected to any device as long as the distribution cable is connected between the control chamber and the heat dissipation chamber.

### Reference Signs List

- 1: Inverter device
- 10a: Control chamber
- 10b: Heat dissipation chamber
- 11: Front surface cover
- 12: Rear surface cover (cover member)
- 12a: Through hole (hole portion)
- 13: Side cover
- 14: Top plate
- 15: Bottom plate
- 16: Frame
- 17: Cooling fins
- 18: Cooling fan
- 19: Direct current reactor
- 20: Grommet member
- 20a: Hollow portion
- 21: Base portion
- 21a: Base end side region
- 21b: Leading end side region
- 211: Projecting piece
- 212: Level difference
- 22: Guide portion
- 221: Base end portion
- 222: Leading end portion
- C: Distribution cable
- S: Slit

## Claims

1. An inverter device (1) wherein a control chamber (10a) which mainly houses various control circuit devices and the waterproof properties of which are secured, and a heat dissipation chamber (10b), which mainly houses heat dissipation devices for cooling the internal atmosphere of the control chamber (10a) and one portion of which is opened to the external, are installed side by side so as to be adjacent to each other, the inverter device (1) being **characterized by** including:
a cylindrical grommet member which is provided in a condition in which one portion of the grommet member is inserted in a hole portion (12a) formed in a cover member interposed between the control chamber (10a) and the heat dissipation chamber (10b), and which is disposed in a manner such that distribution cables connected between the control chamber (10a) and the heat dissipation chamber (10b) pass through a hollow portion (20a) of the grommet member, wherein
the grommet member has:
a base portion (21) mounted in the hole portion (12a) in a condition in which the base portion (21) passes through the hole portion (12a); and
a guide portion (22) of which a base end portion (221) extends from the base portion (21) toward the heat dissipation chamber (10b) in a front-rear or horizontal direction with the central axis of the base end portion (221) coinciding with the central axis of the base portion (21), and a leading end portion (222) continuous with the base end portion (221) curves downward.

2. The inverter device (1) according to claim 1, **characterized in that**
the guide portion is formed from the same resin material as that of the base portion (21) and configured integrally with the base portion (21), and is smaller in thickness and softer than the base portion (21).

3. The inverter device (1) according to claim 1 or 2, **characterized in that**
a level difference (212) is formed in the base portion (21) by an inner surface of the base portion (21) in a region thereof close to the control chamber (10a) projecting inward.

4. The inverter device (1) according to any one of claims 1 to 3, **characterized in that**
a slit is formed in a lower portion over the entire length of the grommet member (20).

## Patentansprüche

1. Wechselrichtereinrichtung (1), wobei eine Steuerkammer (10a), in welcher hauptsächlich diverse Steuerkreiseinrichtungen untergebracht sind und deren Wasserdichtigkeitseigenschaften gewährleistet sind, und eine Wärmeableitkammer (10b), in welcher hauptsächlich Wärmeableitvorrichtungen zum Kühlen der inneren Atmosphäre der Steuerkammer (10a) untergebracht sind und von der ein Abschnitt nach außen geöffnet ist, Seite an Seite derart installiert sind, dass sie aneinander angrenzend sind, und die Wechselrichtereinrichtung (1) ist **dadurch gekennzeichnet, dass** sie aufweist:
ein zylindrisches Durchführungsglied, das in einem Zustand bereitgestellt ist, in dem ein Abschnitt des Durchführungsglieds in einen Lochabschnitt (12a) eingeführt ist, welcher in einem Abdeckungsglied ausgebildet ist, das zwischen der Steuerkammer (10a) und der Wärmeableitkammer (10b) angeordnet ist, und das auf eine derartige Weise angeordnet ist, dass Verteilungskabel, die zwischen der Steuerkammer (10a) und der Wärmeableitkammer (10b) verbunden sind, durch einen hohlen Abschnitt (20a) des Durchführungsglieds verlaufen, wobei
das Durchführungslied aufweist:
einen Basisabschnitt (21), der in dem Lochabschnitt (12a) in einem Zustand angebracht ist, in dem der Basisabschnitt (21) durch den Lochabschnitt (12a) hindurch verläuft; und
einen Führungsabschnitt (22), von dem ein Basisendabschnitt (221) von dem Basisabschnitt (21) in Richtung der Wärmeableitkammer (10b) in einer Vorn-hinten-Richtung oder einer horizontalen Richtung verläuft, wobei die Mittenachse des Basisendabschnitts (221) mit der Mittenachse des Basisabschnitts (21) zusammenfällt, und ein führender Endabschnitt (222), der mit dem Basisendabschnitt (221) durchgängig ist, sich nach unten krümmt.

2. Wechselrichtereinrichtung (1) nach Anspruch 1, **dadurch gekennzeichnet, dass**
der Führungsabschnitt aus dem gleichen Kunststoffmaterial wie der Basisabschnitt (21) ausgebildet und einstückig mit dem Basisabschnitt (21) eingerichtet ist und eine kleinere Dicke aufweist und weicher ist als der Basisabschnitt (21).

3. Wechselrichtereinrichtung (1) nach Anspruch 1 oder 2, **dadurch gekennzeichnet, dass**
in dem Basisabschnitt (21) von einer Innenfläche des Basisabschnitts (21) in einem Bereich davon in der Nähe der Kontrollkammer (10a) ein nach innen ragender Niveauunterschied (212) ausgebildet ist.

4. Wechselrichtereinrichtung (1) nach einem der Ansprüche 1 bis 3, **dadurch gekennzeichnet, dass**
in einem unteren Abschnitt über die gesamte Länge des Durchführungsglieds (20) ein Schlitz ausgebildet ist.

## Revendications

1. Dispositif onduleur (1) dans lequel une chambre de commande (10a), qui contient principalement différents dispositifs de circuit de commande et dont les propriétés d'étanchéité sont assurées, et une chambre de dissipation de chaleur (10b), qui contient principalement des dispositifs de dissipation de chaleur destinés à refroidir l'atmosphère intérieure de la chambre de commande (10a) et dont une partie est ouverte vers l'extérieur, sont disposées côte à côte de façon à être adjacentes l'une à l'autre, le dispositif onduleur (1) étant **caractérisé en ce qu'**il comprend :
un élément d'oeillet cylindrique qui est prévu dans un état dans lequel une partie de l'élément d'oeillet est insérée dans une partie d'orifice (12a) formée dans un élément de couvercle interposé entre la chambre de commande (10a) et la chambre de dissipation de chaleur (10b), et qui est disposé de manière à ce que les câbles de distribution reliés entre la chambre de commande (10a) et la chambre de dissipation de chaleur (10b) passent à travers une partie creuse (20a) de l'élément d'oeillet, dans lequel
l'élément d'oeillet possède :
une partie de base (22) montée dans la partie d'orifice (12a) dans un état dans lequel la partie de base (21) passe à travers la partie d'orifice (12a) ; et
une partie de guidage (22) dont une partie d'extrémité de base (221) s'étend depuis la partie de base (21) en direction de la chambre de dissipation de chaleur (10b) dans la direction avant-arrière ou horizontale avec l'axe central de la partie d'extrémité de base (221) qui coïncide avec l'axe central de la partie de base (21), et une partie d'extrémité avant (222) continue avec la partie d'extrémité de base (221) est incurvée vers le bas.

2. Dispositif onduleur (1) selon la revendication 1, **caractérisé en ce que**
la partie de guidage est formée à partir du même matériau de résine que celui de la partie de base (21) et est configurée intégralement avec la partie de base (21), et est moins épaisse et plus souple que la partie de base (21).

3. Dispositif onduleur (1) selon la revendication 1 ou 2, **caractérisé en ce que**
une différence de niveau (212) est formée dans la partie de base (21) par une surface interne de la partie de base (21) dans une zone de celle-ci proche de la chambre de commande (10a) qui se projette vers l'intérieur.

4. Dispositif onduleur (1) selon l'une quelconque des revendications 1 à 3, caractérisé en ce
une encoche est formée dans une partie inférieure sur toute la longueur de l'élément d'oeillet (20).
